# EUROPEAN PATENT APPLICATION

(11) **EP 4 530 652 A1**
(43) Date of publication of application: **02.04.2025**
(21) Application number: 23200724.5
(22) Date of filing: 29.09.2023
(51) Int. Cl.: G01R 33/36

(54) **RADIO FREQUENCY RECEIVER ANTENNA ASSEMBLY**

(71) Applicant: Koninklijke Philips N.V., 5656 AG Eindhoven (NL)
(72) Inventor: FINDEKLEE, Christian, Eindhoven (NL); VERNICKEL, Peter, Eindhoven (NL); LEUSSLER, Christoph Günther, 5656AG Eindhoven (NL)
(74) Representative: Philips Intellectual Property & Standards

(57) **Abstract**

Disclosed herein is a radio frequency receiver antenna assembly (100), which comprises a radio frequency receiver coil for magnetic resonance imaging (102), a detuning assembly (104) configured for operating the receiver coil (102) in a tuned operational mode (180) and a detuned operational mode (182), and a controlling unit (108). The detuning assembly (104) comprises a switch (106) configured for switching between the tuned operational mode (180) and the detuned operational mode (182). The controlling unit is configured for controlling the switch (106).

The radio frequency receiver antenna assembly (100) is configured for receiving a wireless radio frequency definition signal (152); determining a control sequence (158) for controlling the switch by the controlling unit; receiving the wireless radio frequency trigger signal (154); and, in response to receiving the trigger signal (154), switching by the controlling unit the receiver coil (102) between the tuned operational mode (180) and the detuned operational mode (182) according to the control sequence (158) by the controlling unit (108) using the switch (106).

## Description

### FIELD OF THE INVENTION

The invention relates to magnetic resonance imaging, in particular to a radio frequency receiver antenna assembly comprising a radio frequency receiver coil for magnetic resonance imaging, a magnetic resonance imaging system comprising the radio frequency receiver antenna assembly, a computer program comprising machine executable instructions for execution by a computational component of a controlling unit of the radio frequency receiver antenna assembly, and a method for controlling the radio frequency receiver antenna assembly.

### BACKGROUND OF THE INVENTION

In magnetic resonance imaging (MRI) systems, radio frequency (RF) receiver coils are tuned to be sensitive for a resonance frequency of nuclei being excited in a target zone of the MRI system, i.e., the Larmor frequency of nuclei to be imaged. For the exciting of the nuclei, RF pulses are transmitted at the resonance frequency, i.e., using the resonance frequency as a carrier frequency. During the stimulation phase of MRI, large amounts of power at the resonance frequency may be transmitted by the RF pulses. Since the RF receiver coils are tuned to this same frequency, a temporary detuning of the RF receiver coils during the transmission of the RF pulses may be required, in order to protect the RF receiver coils and associated circuitry from such large amounts of power and to avoid transmit field distortions due to eddy currents which also come with risks for the patient.

To prevent problems with the RF receiver coils, e.g., from being burned out by the powerful RF pulses, the coils may temporarily be switched to a detuned operational mode, in which they are not tuned to the resonance frequency anymore and a sensitivity for the RF field (B₁) transmitting the pulses is reduced. Such a switching between the tuned operational mode and the detuned operational mode may, e.g., be controlled by an MRI backend via a dedicated tuning line, i.e., cable, transmitting commands to the receiver coils, in order to switch the same between the tuned operational mode and the detuned operational mode.

However, besides the additional complexity, such a dedicated tuning line may by itself cause further problems like a coupling to MRI transmitting and/or receiving fields resulting in negative effects on patient safety and/or image quality.

### SUMMARY OF THE INVENTION

The invention provides for a radio frequency receiver antenna assembly comprising a radio frequency receiver coil for magnetic resonance imaging, a magnetic resonance imaging system comprising such a radio frequency receiver antenna assembly, a computer program comprising machine executable instructions for execution by a computational component of a controlling unit of such a radio frequency receiver antenna assembly, and a method for controlling such a radio frequency receiver antenna assembly.

In one aspect, the invention provides for a radio frequency receiver antenna assembly comprising a radio frequency receiver coil for magnetic resonance imaging, a detuning assembly configured for operating the receiver coil in a tuned operational mode and a detuned operational mode, and a controlling unit. The detuning assembly comprises a switch configured for switching between the tuned operational mode and the detuned operational mode. The controlling unit is configured for controlling the switch in response to a wireless radio frequency trigger signal being received via the receiver coil.

The radio frequency receiver antenna assembly is configured for:
receiving a wireless radio frequency definition signal by the controlling unit via the receiver coil defining an MRI sequence comprising one or more radio frequency pulses;
in response to the receiving of the wireless radio frequency definition signal, determining a control sequence for controlling the switch by the controlling unit using the received wireless radio frequency definition signal, the control sequence controlling the switch to operate the receiver coil in the detuned operational mode during a transmission of the pulses of the MRI sequence and in the tuned operational mode during the rest of the MRI sequence;
receiving the wireless radio frequency trigger signal by the controlling unit via the receiver coil;
in response to the receiving of the wireless radio frequency trigger signal, switching the receiver coil between the tuned operational mode and the detuned operational mode according to the control sequence by the controlling unit using the switch.

The RF receiver antenna assembly is configured for operating the RF receiver coil selectively in the tuned operational mode and the detuned operational mode using the detuning assembly. In the tuned operational mode, the RF receiver coil is tuned to be sensitive for a resonance frequency of nuclei being excited in a target zone of the MRI system, i.e., the Larmor frequency of the nuclei to be imaged. In the detuned operational mode, the RF receiver coil is not tuned to the resonance frequency anymore and the coupling to the RF field (Bi) used to excite the nuclei is reduced.

During the stimulation phase of MRI, large amounts of power, e.g., exceeding 10 kW, may be transmitted at the resonance frequency into the magnet bore of the MRI system by the B₁ field. The RF receiver coil and associated circuitry is tuned to the same frequency in the tuned operational mode enabling the RF receiver coil to ultimately detect the emitted MRI signals. This means, that the RF receiver coil is tuned to this frequency. However, during a pulse, the RF receiver coil is switched to the detuned operational mode using the detuning assembly, e.g., for protecting the coil and/or a patient. When the RF receiver coil is not in the detuned operational state, it may be in the tuned operational state. Due to a high transmit pulse power there may be more than enough signal power to detect that pulse even in the detuned operational mode, since the detuning assembly may reduce that signal power level of a received signal by, e.g., just around 20 to 45 dB. Electronically "detuning" the RF receiver coil briefly during RF pulse transmission may prevent problems with the RF receiver coil, e.g., from being burned out by powerful RF pulses.

Using the controlling unit, an intelligent local control of a switching of the receiver coil between different operational modes is implemented. The controlling unit is inter alia configured as a switch driver for operating the switch, in order to switch the receiver coil between the tuned operational mode and the detuned operational mode. The switch may, e.g., comprise a PIN (positive intrinsic negative) diode, a FET (field-effect transistor), a MEM (micro-electro-mechanical) switch or the like for switching.

The RF receiver antenna assembly is configured receive via the RF receiver coil wireless RF signals, which provide the controlling unit with information that enable the controlling unit to determining a control sequence for an MRI sequence. The control sequence is used by the controlling unit to control the switch of the detuning assembly, such that the receiver coil is operated in the detuned operational mode during a transmission of the pulses of the respective MRI sequence and in the tuned operational mode during the rest of the MRI sequence.

The wireless RF signals comprise at least a wireless RF definition signal providing information, which enables the controlling unit to determine the control sequence. The wireless RF definition signal may, e.g., describe the MRI sequence for which the control sequence is to be determined and/or it may, e.g., describe the control sequence to be used for controlling the switch, while the MRI sequence is received.

The wireless RF signals further comprise a wireless RF trigger signal triggering the controlling unit to execute the control sequence, i.e., to switch the RF receiver coil between the tuned operational mode and the detuned operational mode according to the control sequence. This trigger signal may be used for synchronizing the execution of the control sequence with a transmission of the MRI sequence.

The wireless RF definition signal and/or the wireless RF trigger signal may, e.g., be provided in form of the pulses according to a pulse sequence.

For processing the RF signals received via the RF receiver coil, the controlling unit may, e.g., comprise a digital receiver. The digital receiver may, e.g., be configured for amplifying the RF signals received via the RF receiver coil, e.g., using a low-noise preamplifier, for digitizing analog RF signals received via the RF receiver coil using a high frequency analog-to-digital converter (ADC), and/or for demodulating the RF signals received via the RF receiver coil, i.e., extracting information from the RF signals. The digital receiver may be configured to detect and process the RF definition signal and the RF trigger signal received as wireless signals via the RF receiver coil, e.g., when the receiver coil is operated in the detuned operational mode.

The RF receiver antenna assembly may, e.g., comprise a single RF receiver coil being switched by the controlling unit using the determined controlling sequence. The RF receiver antenna assembly may, e.g., comprise a plurality of two or more RF receiver coils being switched by the controlling unit using the determined controlling sequence.

The controlling unit may be configured to operate the switch of the detuning assembly based on the control sequence determined using the received wireless RF definition signal, e.g., an RF transmit field comprising pulses according to a pulse sequence. The controlling unit may further be configured to infer an upcoming transmit pulse pattern using the received wireless RF trigger signal, e.g., an RF transmit field comprising pulses according to a pulse sequence.

The RF receiver antenna assembly may, e.g., be configured for detecting a transmit pulse sequence automatically using the RF receiver coil and the controlling unit as well as for switching between operational modes on its own using the control sequence.

Examples may have the beneficial that an amount of cabling to the RF receiver antenna assembly may be reduced. For example, a need for an additional cabling to the RF receiver antenna assembly to transmit control signals for controlling a switching of the RF receiver coil between the tuned operational mode and the detuned operational mode may be avoided. Any signals, e.g., the definition signal and the trigger signal, may be received in form of wireless RF signals via the RF receiver coils to the RF receiver antenna assembly.

Providing the signals used for defining the control sequence as well as for triggering the execution of the respective control sequence in form of wireless RF signals received via the RF receiver coil, no signal transmission line to the RF receiver antenna assembly may be required. Data required by the controlling unit may, e.g., be transmitted exclusively in wireless form using the abilities of the receiver antenna assembly. Thus, e.g., no data may be transmitted from an MRI backend to the receiver antenna assembly via wires.

For example, data may only be transmitted via wires from the receiver antenna assembly to the MRI backend. This wire-based transmission data are the MRI receive signals, i.e., acquired MRI data, which are transmitted in analog or digital form from the receiving receiver antenna assembly to the MRI backend of the MRI system, i.e., to a data processing unit of the MRI system for further processing. This further processing may, e.g., comprise generating images using the acquired MRI data.

The control sequence may define when to switch between the tuned operational mode and the detuned operational mode. For example, the control sequence may define an alternating sequence between the tuned operational mode and the detuned operational mode. For example, the control sequence may define lengths of temporal intervals during which the RF receiver coil is to be operated in the tuned operational mode or the detuned operational mode, while an MRI sequence of an MRI RF signal is received. The control sequence for a pulse sequence may define temporal intervals during which pulses of the MRI sequence are transmitted and the RF receiver coil is to be operated in the detuned operational mode as well as temporal intervals during which no pulses of the MRI sequence are transmitted and the RF receiver coil is to be operated in the tuned operational mode.

The wireless RF trigger signal may, e.g., comprise the MRI sequence defined by the wireless RF definition signal. The wireless RF trigger signal may, e.g., not comprise the MRI sequence. The wireless RF trigger signal may, e.g., comprise a trigger assigned to the MRI sequence and/or to a starting of a transmission of the MRI sequence. A trigger assigned to the MRI sequence may, e.g., be an MRI sequence ID. A trigger indicative of a starting of a transmission of the MRI sequence may, e.g., be a switching of a carrier frequency of an RF signal being received, e.g., the RF definition signal, from a non-resonant frequency to a resonance MRI frequency.

A start of the control sequence may be defined relative to a reception of the wireless RF trigger signal. Thus, the wireless RF trigger signal may be used for a synchronization of the execution of the control sequence with an MRI data acquisition procedure executed by an MRI system comprising the RF receiver antenna assembly. The wireless RF trigger signal may be a dedicated synchronization signal indicating an immediate start of a transmission of an MRI sequence or a start of the transmission after a pre-defined period of time. The wireless RF trigger signal may be provided in form of switching of a carrier frequency of an RF signal received by the RF receiver coil from a non-resonant frequency to a resonance MRI frequency. The switching of the carrier frequency may indicate the start of the MRI sequence. While using the non-resonant RF frequency nuclei within a target zone of an MRI system may not be excited. When switching the resonance RF frequency, the nuclei may be excited and an MRI data acquisition may be start.

Thus, the control sequence may define a prospective sequence of switching between the tuned operational mode and the detuned operational mode of the receiver coil in response to the receiving of the wireless RF definition signal and start the execution of the control sequence in response to the receiving of the wireless RF trigger signal.

Examples may enable a switching of the receiver coil between the detuned operational mode and the tuned operational mode based on a temporal pattern of pulses determined for an MRI sequence using the RF definition signal. For example, the pattern to be used may already be determined using an onset of a wireless RF signal received via the receiver coil. For example, an end of the respective RF signal, i.e., a first transmission or a repetitive transmission of the RF signal may be used as a trigger for triggering the controlling unit of the RF receiver antenna assembly to execute the determined control sequence during reception of one or more repetitions of the respective RF signal.

Rather than using some form of posteriori detection of a high-power transmit pulse for determining a detuning or tuning requirement of the receiver coil and react to the same, a prospective definition of a required switching between the tuned operational mode and the detuned operational mode of the receiver coil in form of the control sequence may be used. The control sequence may define a prospective switching pattern, which is executed in response to the reception of the RF trigger signal.

Alternatively, the determining of the control sequence and the switching of the receiver coil between operational modes according to the control sequence based on wireless RF signals received via the RF receiver coil may, e.g., be implemented in addition to a dedicated signal line configured for transferring a control signal to the controlling unit for controlling the switching of the receiver coil between operational states. The additional usage of the wireless RF signals for initiating and controlling the switching may implement a redundant detuning of the RF receiver coil as a safety feature. Thus, whenever a detuning command is missed for any reason, the redundant detuning command provided via the dedicated signal line or defined by the control sequence, may ensure that a detuning is executed. For example, a detuning command, whether received via the dedicated signal line or defined by the control sequence, may be dominant over any tuning command. Thus, even in case of contradicting commands, it may be ensured that it is the detuning command, which is executed ensuring a safe operating of the RF receiver coil.

For example, the determining of the control sequence comprises determining a temporal pattern of pulses of the MRI sequence using the wireless radio frequency definition signal. The determined temporal pattern of pulses is used for the determining of the control sequence.

The determined temporal pattern of pulses may comprise one or more of the following features determined by the controlling unit using the received RF definition signal: values describing a relative temporal distribution of the pulses, values describing temporal durations of the pulses and/or a value describing a temporal length of the MRI sequence.

For example, the wireless radio frequency definition signal comprises the MRI sequence. The MRI sequence is used for the determining of the temporal pattern of pulses.

The MRI sequence may, e.g., be transmitted using a non-resonant carrier frequency. The controlling unit may be configured to analyze the MRI sequence and determine one or more features of the MRI sequence and/or the temporal pattern of pulses of the MRI sequence. These features may, e.g., comprise values describing a relative temporal distribution of the pulses, values describing temporal durations of the pulses and/or a value describing a temporal length of the MRI sequence. The determined features of the MRI sequence and/or the temporal pattern of pulses of the MRI sequence may be used to determine the temporal pattern of pulses.

Examples may have the beneficial feature of implementing a self-tuning and selfdetuning functionality for the receiver coil. For implementing this functionality, the RF receiver antenna assembly comprises the controlling unit for controlling the RF receiver coil. The controlling unit analyzes the MRI sequence comprised by the wireless RF definition signal and determines the control sequence based on the result of the analysis to be used for a tuning and detuning of the receiver coil.

MRI sequences may show a repetitive pattern, an MRI RF signal may comprise one or more repetitions of the MRI sequence. The controlling unit may, e.g., determine the pattern of the pulse sequence, i.e., the temporal pattern of pulses, from a first run. This first run may be the wireless RF definition signal. Then, the controlling unit may switch the receiver coil automatically according to the control sequence determined using the temporal pattern of pulses acquired from the first run. According to the control sequence, the receiver coil may be switched to the detuned operational mode during the pulses and to the tuned operational mode during the acquisition phase.

The pulse sequence may be detected during the first run for a complete series of pulses to synchronize the controlling unit to the exact clock of the pulses. For example, this first run, i.e., the first pulse sequence may not be used for imaging purposes, since the receiver coil may not be operated in the tuned operational mode during the receiving of the wireless RF definition signal, i.e., the first run. For example, the first pulse sequence may be an additional pulse sequence sent before sending the actual pulse sequences for imaging purposes. This additional pulse sequence, i.e., the wireless RF definition signal may, e.g., be sent using a non-resonant RF frequency outside an MRI RF bandwidth to avoid exciting nuclei in a target zone of the MRI system during transmission of the additional pulse sequence. A switching from the non-resonant RF frequency to a resonance RF frequency within the MRI RF bandwidth may trigger the controlling unit as an RF trigger signal to execute the control sequence.

For example, the wireless radio frequency definition signal further comprises at least one repetition of the MRI sequence. For example, the wireless radio frequency definition signal further comprises a plurality of repetitions of the MRI sequence.

For example, the control unit may comprise a machine learning module trained to output a control sequence in response to receiving an MRI sequence. For example, the MRI sequence may be provided as input to the machine learning module by the controlling unit. The MRI sequence may be provided by the wireless RF definition signal received by the controlling unit via the RF receiver coil. The machine learning module may, e.g., be stored in a memory comprised by the controlling unit.

The machine learning module may be trained to predict a control sequence as an output for an MRI sequence as an input. For training the machine learning module, an untrained or partially pre-trained machine learning module to be trained may be provided. The machine learning module to be trained may be trained using training datasets. Each training dataset may, e.g., comprise a training MRI sequence to be used as a training input and a training control sequence to be used as training output. The machine learning module is trained using the training datasets to provide the training control sequences as output in response to receiving the corresponding training MRI sequences as input. The resulting trained machine learning module is configured to output a control sequence in response to receiving an MRI sequence as input.

Examples may implement a machine learning based switch control by the controlling unit using the machine learning module. This machine learning based switch control may be configured to return a switch control signal for controlling the switch of the detuning assembly in form of the control sequence from the wireless RF definition signal comprising an MRI sequence, which is received via the RF receiver coil.

Thus, a prospective detuning and tuning based on a machine learning based expectation of an MRI sequence may be implemented. The machine learning module may be used for estimating a control sequence for a temporal pattern of pulses.

For example, the wireless radio frequency definition signal comprising definitions of one or more features of the temporal pattern of pulses encoded in the wireless radio frequency definition signal. The controlling unit is configured to decode the one or more features of the temporal pattern of pulses using the wireless radio frequency definition signal. The decoded one or more features of the temporal pattern of pulses are used for the determining of the temporal pattern of pulses.

The wireless RF definition signal may, e.g., comprise one or more definitions of one or more features of the MRI sequence and/or the temporal pattern of pulses of the MRI sequence. These features may, e.g., comprise values describing a relative temporal distribution of the pulses, values describing temporal durations of the pulses and/or a value describing a temporal length of the MRI sequence. The received features of the MRI sequence and/or the temporal pattern of pulses of the MRI sequence may be used to determine the temporal pattern of pulses.

For example, the controlling unit is configured to decode the one or more features of the temporal pattern of pulses using one or more of the following: an amplitude modulation analysis, a frequency modulation analysis, a Manchester code analysis, a pulse-width modulation analysis.

The controlling unit may be configured to decode the one or more features of the temporal pattern of pulses using an amplitude modulation analysis, a frequency modulation analysis, a Manchester code analysis, and/or a pulse-width modulation analysis of the wireless RF signal received via the RF receiver coil.

For example, the controlling unit comprises a memory. One or more additional features of the temporal pattern of pulses are pre-stored in the memory. The pre-stored one or more additional features of the temporal pattern of pulses is used for the determining of the temporal pattern of pulses.

These additional features may, e.g., comprise values describing a relative temporal distribution of the pulses, values describing temporal durations of the pulses and/or a value describing a temporal length of the MRI sequence. The additional features of the temporal pattern of pulses of the MRI sequence may be used to determine the temporal pattern of pulses.

For example, the receiving of the wireless radio frequency trigger signal comprises comparing a temporal pattern of pulses of an MRI sequence comprised by the wireless radio frequency trigger signal with the determined temporal pattern of pulses. The switching of the receiver coil according to the control sequence is triggered by a determining of a matching of the temporal pattern of pulses of the wireless radio frequency trigger signal with the determined temporal pattern of pulses.

For example, the determined temporal pattern of pulses may be assigned to the determined control sequence. Using the determined temporal pattern of pulses, the controlling unit may detect the temporal pattern of pulses of the wireless RF trigger signal, i.e., a transmit pulse sequence being used for MRI data acquisition, automatically and switch the receiver coil between the tuned operational mode and the detuned operational mode using the control sequence without requiring further input.

For example, the wireless RF trigger signal is received after the wireless radio frequency definition signal. The RF trigger signal may, e.g., be equal to the RF definition signal. Both signals may, e.g., comprise the MRI sequence. For example, a first transmission of the MRI sequence may be used as the RF definition signal for determining the temporal pattern of pulses as well as the control sequence. The temporal pattern of pulses may be assigned to the control sequence. A second transmission of the MRI sequence may, e.g., be used as the RF trigger signal. In case a match of a temporal pattern of pulses of the MRI sequence of the RF trigger signal with the temporal pattern of pulses assigned to the determined control sequence is determined, the controlling unit is triggered to execute the assigned control sequence.

For example, a plurality of different temporal patterns of pulses as well as different control sequences may be determined for a plurality of different RF definition signals. The determined pairs of control sequences and assigned temporal patterns of pulses may, e.g., be stored in a memory of the controlling unit. Upon reception of an RF trigger signal comprising an MRI sequence, a temporal pattern of pulses of the MRI sequence is determined by the controlling unit and compared to the stored temporal patterns of pulses. In case of a match with one of the stored temporal patterns of pulses, the controlling unit may select the control sequence, to which the matching temporal pattern of pulses is assigned. The selected control sequence may be used by the controlling unit for switching the receiver coil loop between the tuned operational mode and the detuned operational mode.

For example, the receiving of the wireless radio frequency trigger signal comprises determining a switching of a carrier frequency of a received RF signal from a non-resonant frequency of the RF definition signal to a resonance frequency of an MRI RF signal. The switching of frequency may be the RF trigger signal triggering the controlling unit.

For example, the wireless radio frequency trigger signal is the wireless radio frequency definition signal defining the temporal pattern of pulses and triggering the switching of the receiver coil. The switching of the receiver coil according to the control sequence is triggered automatically at an end of the receiving of the wireless radio frequency definition signal.

In this case one signal may be used for determining the control sequence and for triggering an automatic execution of the determined control sequence by the controlling unit at the end of the transmission of the wireless RF definition signal.

For example, the wireless radio frequency trigger signal is a pre-defined trigger signal. The controlling unit is configured to start the switching of the receiver coil according to the control sequence at a pre-defined temporal duration after the receiving of the pre-defined trigger signal.

The RF trigger signal may, e.g., be a dedicated signal indicating a start of an MRI RF pulse signal. For example, the RF trigger signal may be a switching of a carrier sequence. For example, the RF trigger signal may comprise a trigger encoded in the wireless RF trigger signal. The controlling unit may be configured to decode the trigger using the wireless RF trigger signal. For example, the controlling unit is configured to decode the trigger using one or more of the following: an amplitude modulation analysis, a frequency modulation analysis, a Manchester code analysis, a pulse-width modulation analysis.

The pre-defined temporal duration may be equal to or larger than zero. For example, the controlling unit is configured to start the switching of the receiver coil instantaneously after the receiving of the pre-defined trigger signal, i.e., at a pre-defined temporal duration equal zero after the receiving of the pre-defined trigger signal. For example, the controlling unit is configured to start the switching of the receiver coil after a pre-defined interval of time has passed, i.e., at a pre-defined temporal duration larger than zero after the receiving of the pre-defined trigger signal. The pre-defined interval of time starts instantaneously after the receiving of the pre-defined trigger signal.

For example, the radio frequency receiver antenna assembly is configured to operate the receiver coil by default in the detuned operational mode. Operating the receiver coil by default in the detuned operational mode may be used as a safety feature.

In the detuned operational mode, a pickup of RF energy by the receiver coil may be suppressed, in order to avoid excessive pickup peaks, which could, e.g., result in a burning of a patient in a region being scanned by an MRI system. Since the receive functionality is only suppressed, e.g., by temporally adding an additional impedance to the RF receiver coil, the receiver coil may even in the detuned operational mode be sensitive enough for the receiving wireless RF definition signal as well as the wireless RF trigger signal.

For example, the switch of the detuning assembly is arranged within a loop of the receiver coil and the detuning assembly is configured to interrupt electrical currents induced in the receiver coil by magnetic resonance imaging radio frequency fields in the detuned operational mode using the switch. Interrupting the electrical currents may prevent the RF receiver coil from an excessive pickup of RF energy transmitted by RF pulses, when operated in the detuned operational mode. The switch may, e.g., be realized by a series switch, which is closed to operate the loop of the receiver coil.

For example, the detuning assembly comprises a switchable impedance electrically conductively connected with a loop of the receiver coil in parallel. The switchable impedance is switchable using the switch of the detuning assembly. By activating the switchable impedance, the impedance of the RF receiver coil may be increased and the RF receiver coil be prevented from an excessive pickup of RF energy transmitted by RF pulses, when operated in the detuned operational mode. The switchable impedance may, e.g., be switched using a PIN (positive intrinsic negative) diode, a FET (field-effect transistor), a MEM (micro-electro-mechanical) switch or the like as the switch.

The switchable impedance may, e.g., be implemented using an inductor, which is switched using switch. The switch may, e.g., activate an inductor arranged in parallel to a resonance capacitor in a loop of the receiver coil. Such a setup may be beneficial for SNR reasons, i.e., in order to increase the signal-to-noise ratio (SNR).

In another aspect, the invention provides for a magnetic resonance imaging system comprising the radio frequency receiver antenna assembly of any of the previous examples. The RF receiver coil of the RF receiver antenna assembly may be used for receiving MRI RF signals from excited nuclei within a target zone of the MRI system. The RF receiver antenna assembly may comprise one or more RF receiver coils or coil elements controlled by the controlling unit. For example, the MRI system may comprise a plurality of RF receiver antenna assemblies.

For example, the magnetic resonance imaging system is configured to transmit the wireless RF definition signal. For example, the magnetic resonance imaging system is configured to transmit the wireless RF trigger signal.

For example, the magnetic resonance imaging system is configured to transmit the wireless RF definition signal and/or the wireless RF trigger signal at a radio frequency outside a pre-defined MRI frequency bandwidth used by the MRI system for exciting nuclei within the target zone of the MRI system.

In another aspect, the invention provides for a computer program comprising machine executable instructions for execution by a computational component of a controlling unit of a radio frequency receiver antenna assembly. The radio frequency receiver antenna assembly comprises a radio frequency receiver coil for magnetic resonance imaging, a detuning assembly configured for operating the receiver coil in a tuned operational mode and a detuned operational mode, and the controlling unit. The detuning assembly comprises a switch configured for switching between the tuned operational mode and the detuned operational mode. The controlling unit is configured for controlling the switch in response to a wireless radio frequency trigger signal being received via the receiver coil.

Execution of the machine executable instructions by the computational component causes the computational component to control the radio frequency receiver antenna assembly to:
receive a wireless radio frequency definition signal by the controlling unit via the receiver coil defining an MRI sequence comprising one or more radio frequency pulses;
in response to the receiving of the wireless radio frequency definition signal, determine a control sequence for controlling the switch by the controlling unit using the received wireless radio frequency definition signal, the control sequence controlling the switch to operate the receiver coil in the detuned operational mode during a transmission of the pulses of the MRI sequence and in the tuned operational mode during the rest of the MRI sequence;
receive the wireless radio frequency trigger signal by the controlling unit via the receiver coil;
in response to the receiving of the wireless radio frequency trigger signal, switch the receiver coil between the tuned operational mode and the detuned operational mode according to the control sequence by the controlling unit using the switch.

For example, the machine executable instructions may be configured for controlling any of the aforementioned examples of an RF receiver antenna assembly.

For example, the computer program may be provided in the form of a software package. This software package may, e.g., be used for upgrading an already installed software to enable an RF receiver antenna assembly, e.g., an RF receiver antenna assembly installed in a magnetic resonance imaging system, to operate according to the examples described herein.

In another aspect, the invention provides for a method for controlling a radio frequency receiver antenna assembly comprising a radio frequency receiver coil for magnetic resonance imaging, a detuning assembly configured for operating the receiver coil in a tuned operational mode and a detuned operational mode, and a controlling unit. The detuning assembly comprises a switch configured for switching between the tuned operational mode and the detuned operational mode. The controlling unit is configured for controlling the switch in response to a wireless radio frequency trigger signal being received via the receiver coil.

The method comprises:
receiving a wireless radio frequency definition signal by the controlling unit via the receiver coil defining an MRI sequence comprising one or more radio frequency pulses;
in response to the receiving of the wireless radio frequency definition signal, determining a control sequence for controlling the switch by the controlling unit using the received wireless radio frequency definition signal, the control sequence controlling the switch to operate the receiver coil in the detuned operational mode during a transmission of the pulses of the MRI sequence and in the tuned operational mode during the rest of the MRI sequence;
receiving the wireless radio frequency trigger signal by the controlling unit via the receiver coil;
in response to the receiving of the wireless radio frequency trigger signal, switching the receiver coil between the tuned operational mode and the detuned operational mode according to the control sequence by the controlling unit using the switch.

For example, the method may be configured for controlling any of the aforementioned examples of an RF receiver antenna assembly.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit", "module" or "system". Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A `computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid-state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

`Computer memory' or 'memory' is an example of a computer-readable storage medium. Computer memory is any memory which is directly accessible to a computational system. `Computer storage' or 'storage' is a further example of a computer-readable storage medium. Computer storage is any non-volatile computer-readable storage medium. In some embodiments computer storage may also be computer memory or vice versa.

A `computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A `user interface' as used herein is an interface which allows a user or operator to interact with a computer or computer system. A `user interface' may also be referred to as a `human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A `hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or `display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen, Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

The term `machine learning' (ML) refers to a computer algorithm used to extract useful information from training datasets by building probabilistic models, which are referred to as machine learning modules or models, in an automated way. A machine learning module may also be referred to as a predictive model. Machine learning algorithms build a mathematical model based on sample data, known as `training data', in order to make predictions or decisions without being explicitly programmed to perform the respective task. The machine learning module may be performed using a learning algorithm such as supervised or unsupervised learning. The machine learning module may be based on various techniques such as clustering, classification, linear regression, reinforcement, self-learning, support vector machines, neural networks, etc. A machine learning module may, e.g., be a data structure or program such as a neural network, in particular a convolutional neural network, a support vector machine, a decision tree, a Bayesian network etc. The machine learning module may be adapted, i.e., trained to predict an unmeasured value. The trained machine learning module may thus be enabled to predict the unmeasured value as output from other known values as input.

A machine learning module to be trained may, e.g., be an untrained machine learning module, a pre-trained machine learning module or a partially trained machine learning module. The machine learning module being trained may be an untrained machine learning module, which is trained from scratch. Alternatively, the machine learning module being trained may be a pre-trained or partially trained machine learning module. In general, it may not be necessary to start with an untrained machine learning module, e.g., in deep learning. For example, one may start with a pre-trained or partially trained machine learning module. The pre-trained or partially trained machine learning module may have been pre-trained or partially trained for the same or a similar task. Using a pre-trained or partially trained machine learning may, e.g., enable a faster training of the trained machine learning module to be trained, i.e., the training may converge faster. For example, transfer learning may be used for training a pre-trained or partially trained machine learning module. Transfer learning refers to a machine learning process, which rather than starting the learning process from scratch starts from patterns that have been previously learned, when solving a different problem. This way previous learnings may, e.g., be leveraged, avoiding to start from scratch. A pre-trained machine learning module is a machine learning module that was trained previously, e.g., on a large benchmark dataset to solve a problem similar to the one to be solved by the additional learning. In case of a pre-trained machine learning module a previous learning process has been completed successfully. A partially trained machine learning module is a machine learning module, which has been partially trained, i.e., the training process may not have been completed yet. A pre-trained or partially machine learning module may, e.g., be import and trained to be used for the purposes disclosed herein.

### BRIEF DESCRIPTION OF THE DRAWINGS

In the following preferred embodiments of the invention will be described, by way of example only, and with reference to the drawings in which:
Fig. 1 illustrates an exemplary method for controlling an RF receiver antenna assembly;
Fig. 2 illustrates a further exemplary method for controlling an RF receiver antenna assembly;
Fig. 3 illustrates a further exemplary method for controlling an RF receiver antenna assembly;
Fig. 4 illustrates an RF receiver antenna assembly;
Fig. 5 illustrates a further RF receiver antenna assembly;
Fig. 6 illustrates a controlling unit of an RF receiver antenna assembly;
Fig. 7 illustrates an exemplary MRI sequence;
Fig. 8 illustrates an exemplary RF definition signal and an exemplary RF trigger signal;
Fig. 9 illustrates an exemplary RF definition signal and an exemplary RF trigger signal;
Fig. 10 illustrates a further example of an MRI system; and
Fig. 11 illustrates a further example of an MRI system.

### DETAILED DESCRIPTION OF EMBODIMENTS

Like numbered elements in these figures are either equivalent elements or perform the same function. Elements which have been discussed previously will not necessarily be discussed in later figures if the function is equivalent.

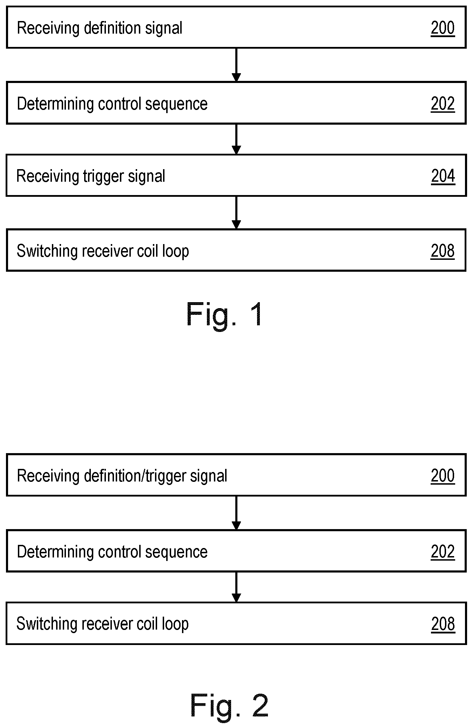

Fig. 1 illustrates a method for controlling an RF receiver antenna assembly by a controlling unit. The RF receiver antenna may comprise an RF receiver coil for magnetic resonance imaging, a detuning assembly configured for operating the receiver coil in a tuned operational mode and a detuned operational mode, and the controlling unit. The detuning assembly comprises a switch configured for switching between the tuned operational mode and the detuned operational mode. The controlling unit is configured for controlling the switch in response to a wireless RF trigger signal being received via the receiver coil.

In block 200, the controlling unit receives a wireless RF definition signal via the receiver coil defining an MRI sequence. The wireless RF definition signal may, e.g., comprise the MRI sequence. The wireless RF definition signal may, e.g., comprise features of the MRI sequence.

In response to the receiving of the wireless RF definition signal in block 200, the controlling unit determines in block 202 a control sequence for controlling the switch using the received wireless RF definition signal. The control sequence controls the switch to operate the receiver coil in the detuned operational mode during a transmission of the pulses of the MRI sequence and in the tuned operational mode during the rest of the MRI sequence. Determining the control sequence may comprise determining a temporal pattern of pulses of the MRI sequence using the wireless RF definition signal. The determined temporal pattern of pulses may be used for the determining of the control sequence.

In block 204, the controlling unit receives the wireless RF trigger signal via the receiver coil. In response to the receiving of the wireless RF trigger signal in block 204, the controlling unit switches in block 208 the receiver coil between the tuned operational mode and the detuned operational mode according to the control sequence using the switch. The RF trigger signal may, e.g., comprise the MRI sequence. The RF trigger signal may, e.g., be a dedicated signal indicating a start of an MRI RF pulse signal. For example, the RF trigger signal may be a switching of a carrier sequence. For example, the RF trigger signal may comprise a trigger encoded in the wireless RF trigger signal.

Fig. 2 illustrates another method for controlling an RF receiver antenna assembly as described in view of Fig. 1 by the controlling unit. The difference between the method illustrated in Fig. 2 and the method illustrated in Fig. 1 is that in case of Fig. 2 the wireless RF trigger signal is at the same time the wireless RF definition signal. Therefore, the controlling unit receives in block 200 an RF signal, which at the same time defines the temporal pattern of pulses and triggers the switching of the receiver coil.

In response to the receiving of the wireless RF signal in block 200, the controlling unit determines in block 202 a control sequence for controlling the switch using the received wireless RF signal as a definition signal. The control sequence controls the switch to operate the receiver coil in the detuned operational mode during a transmission of the pulses of the MRI sequence and in the tuned operational mode during the rest of the MRI sequence.

In response to the receiving of the wireless RF signal in block 200, the controlling unit furthermore switches in block 208 the receiver coil between the tuned operational mode and the detuned operational mode according to the control sequence using the switch. The switching of the receiver coil according to the control sequence is, e.g., triggered automatically at an end of the receiving of the wireless RF signal used as a trigger signal.

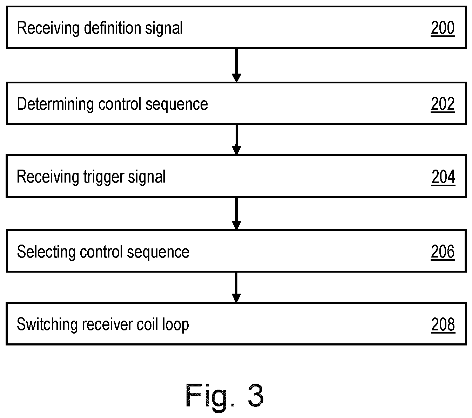

Fig. 3 illustrates another method for controlling an RF receiver antenna assembly as described in view of Fig. 1 by the controlling unit. In block 200, the controlling unit receives a wireless RF definition signal via the receiver coil defining an MRI sequence. In response to the receiving of the wireless RF definition signal in block 200, the controlling unit determines in block 202 a control sequence for controlling the switch using the received wireless RF definition signal. The control sequence controls the switch to operate the receiver coil in the detuned operational mode during a transmission of the pulses of the MRI sequence and in the tuned operational mode during the rest of the MRI sequence.

The determining of the control sequence in block 202 comprising a determining of a temporal pattern of pulses of an MRI sequence using the wireless RF definition signal. The determined temporal pattern of pulses is used for the determining of the control sequence. This control sequence is assigned to the determined temporal pattern of pulses and stored with the assignment in a memory of the controlling unit. Repeating the steps according to blocks 200 and 202 multiple times with different wireless RF definition signals comprising different pulse sequences with different temporal patterns of pulses, a set of a plurality of different control sequences assigned to the different temporal patterns of pulses may be stored in the memory of the controlling unit.

In block 204, the controlling unit receives the wireless RF trigger signal via the receiver coil comprising one of the MRI sequences with a temporal pattern of pulses, for which a control sequence has been determined and stored in the memory of the controlling unit. In block 206, the controlling unit compares a temporal pattern of pulses of the MRI sequence comprised by the wireless RF trigger signal received in block 204 with the temporal patterns of pulses of the control sequences determined and stored before. The controlling unit selects a control sequence of the set of control sequences, which is assigned to a temporal pattern of pulses matching the temporal pattern of pulses of the wireless RF trigger signal received in block 204. In block 208, the controlling unit switches the receiver coil using the switch between the tuned operational mode and the detuned operational mode according to the control sequence selected in block 206.

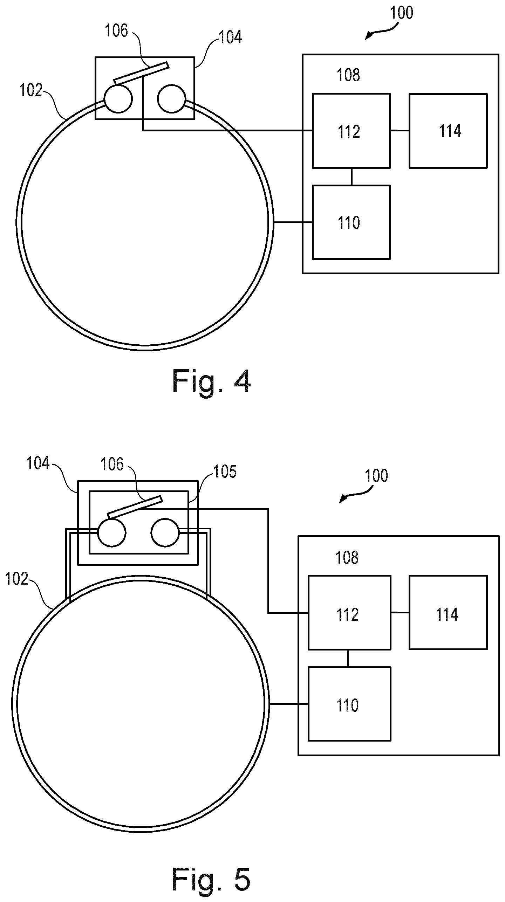

Fig. 4 illustrates an exemplary RF receiver antenna assembly 100. The RF receiver antenna assembly 100 comprise an RF receiver coil 102 for magnetic resonance imaging, a detuning assembly 104 configured for operating the receiver coil 102 in a tuned operational mode and a detuned operational mode, and a controlling unit 108. The detuning assembly 104 comprises a switch 106 configured for switching between the tuned operational mode and the detuned operational mode. The switch 106 may, e.g., comprise a PIN (positive intrinsic negative) diode, a FET (field-effect transistor), a MEM (micro-electro-mechanical) switch or the like for switching.

In the example of Fig. 4, the switch 106 of the detuning assembly 104 is arranged within a loop of the receiver coil 102 and the detuning assembly 104 is configured to interrupt electrical currents induced in the receiver coil 102 by MRI RF fields in the detuned operational mode using the switch 106. If the switch 106 is open, e.g., induced electrical currents are interrupted within the loop and the receiver coil 102 is operated in the detuned operational mode. If the switch 106 is closed, e.g., no interruption is caused by the switch 106 and the receiver coil 102 is operated in the tuned operational mode. The switch 106 may, e.g., be realized by a series switch, which is closed to operate the loop of the receiver coil 102.

The controlling unit 108 is configured for controlling the switch 106 in response to a wireless RF trigger signal being received via the receiver coil 102. The controlling unit 108 may, e.g., comprise a receiver circuit 110 being used as a digital receiver for detecting and processing RF signals, like the definition signal and the trigger signal, received by the RF receiver antenna assembly 100. The controlling unit 108 may further comprise a computational component 112, e.g., a microcontroller, configured for executing machine executable instructions 114, e.g., stored locally in a memory 114 of the controlling unit 108. Execution of the machine executable instructions by the computational component 112 may cause the computational component 112 and thus the controlling unit 108 to control the RF receiver antenna assembly 100 according to any of the method of Fig. 1 to 3.

Fig. 5 illustrates another exemplary RF receiver antenna assembly 100. The RF receiver antenna assembly 100 comprises an RF receiver coil 102 for magnetic resonance imaging, a detuning assembly 104 configured for operating the receiver coil 102 in a tuned operational mode and a detuned operational mode, and a controlling unit 108. The detuning assembly 104 comprises a switch 106 configured for switching between the tuned operational mode and the detuned operational mode.

In the example of Fig. 5, the detuning assembly 104 comprises a switchable impedance 105 electrically conductively connected with a loop of the receiver coil 102 in parallel. The switchable impedance 105 is switchable using the switch 106 of the detuning assembly 104. The switch 106 may, e.g., comprise a PIN (positive intrinsic negative) diode, a FET (field-effect transistor), a MEM (micro-electro-mechanical) switch or the like for switching. If the switch 106 is open, e.g., the switchable impedance 105 is deactivated and the receiver coil 102 is operated in the tuned operational mode. If the switch 106 is closed, e.g., the switchable impedance 105 is activated and the receiver coil 102 is operated in the detuned operational mode. The switchable impedance 105 may, e.g., be implemented using an inductor, which is switched using switch 106. The switch 106 may, e.g., activate an inductor arranged in parallel to a resonance capacitor in the loop of the receiver coil 102. Such a setup may be beneficial for SNR reasons, i.e., in order to increase the signal-to-noise ratio (SNR).

The controlling unit 108 is configured for controlling the switch 106 in response to a wireless RF trigger signal being received via the receiver coil 102. The controlling unit 108 may, e.g., comprise a receiver circuit 110 being used as a digital receiver for detecting and processing RF signals, like the definition signal and the trigger signal, received by the RF receiver antenna assembly 100. The controlling unit 108 may further comprise a computational component 112, e.g., a microcontroller, configured for executing machine executable instructions 120, e.g., stored locally in a memory 114 of the controlling unit 108. Execution of the machine executable instructions 120 by the computational component 112 may cause the computational component 112 and thus the controlling unit 108 to control the RF receiver antenna assembly 100 according to any of the method of Fig. 1 to 3.

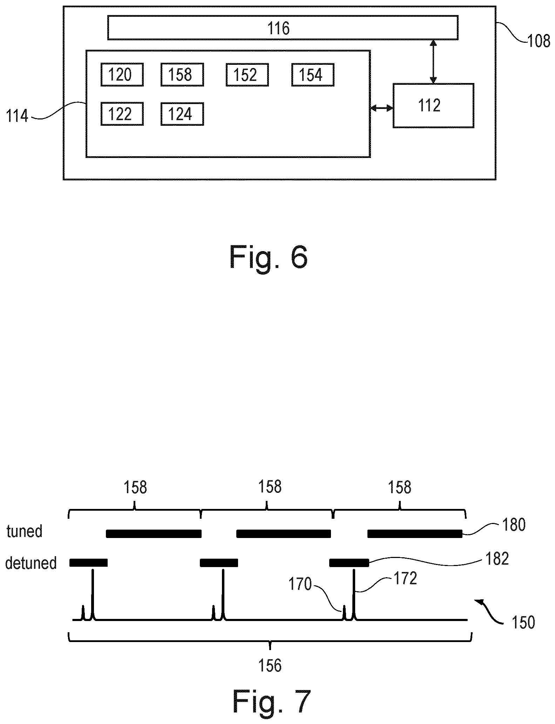

Fig. 6 shows an exemplary controlling unit 108. The controlling unit 108 is shown as comprising a computational component 112. The computational component 112 is intended to represent one or more processors or processing cores or other computational elements. The computational component 112 is shown as being connected to a hardware interface 116 and a memory 114. The hardware interface 116 may enables the computational component 112 to exchange commands and data with other components of the RF receiver antenna assembly, e.g., receiving signal data from the receiver coil or sending commands to detuning assembly for operating the switch. The hardware interface 116 may for example enable the computational component 112 to control the switch of the detuning assembly, in order to switch the receiver coil between the tuned operational mode and the detuned operational mode.

The memory 114 is shown as containing machine-executable instructions 120. The machine-executable instructions 120 enable the computational component 112 to perform tasks such as controlling other components of the RF receiver antenna assembly, to perform numerical tasks, as well as performing various signal data processing tasks. The machine-executable instructions 120 may, e.g., enable the computational component 112 and thus the controlling unit 108 to control the RF receiver antenna assembly 100 according to any of the method of Fig. 1 to 3.

The memory 114 is further shown as containing a control sequence 158 determined using a wireless RF definition signal 152 received by the controlling unit 108 via an RF receiver coil. The control sequence 158 is configured for controlling a switch of a detuning assembly of the RF receiver antenna assembly to operate the RF receiver coil in a detuned operational mode during a transmission of the pulses of an MRI sequence and in a tuned operational mode during the rest of the MRI sequence. The control sequence 158 may be executed by the computational component 112 upon reception of a wireless RF trigger signal 154 by the controlling unit 108 via the RF receiver coil. The RF definition signal 152 as well as the RF trigger signal 154 may be received by the controlling unit 108 via the hardware interface 116, which may be in data communication with the RF receiver coil.

The determining of the control sequence 158 by the computational component 112 may, e.g., comprise determining a temporal pattern of pulses of an MRI sequence comprising one or more radio frequency pulses using the RF definition signal 152. The temporal pattern of pulses may, e.g., be assigned to the control sequence 158 and, e.g., be stored in combination with the control sequence 158 in the memory 114. For example, a plurality of different control sequences 158 may be stored in the memory 114 together with a plurality of different temporal patterns of pulses assigned to the control sequences 158. The different temporal patterns of pulses may, e.g., be used to determine a temporal pattern of pulses matching a temporal pattern of pulses of an RF signal 154 received via the RF receiver coils. A control sequence 158, to which the matching temporal pattern of pulses is assigned, may, e.g., be used for switching the RF receiver coil between the tuned operational mode and the detuned operational mode.

Optionally, the memory 114 may, e.g., comprise one or more additional features 122 of a temporal pattern of pulses of an MRI sequence being used by an MRI system comprising the RF receiver antenna assembly with the controlling unit 108 for MRI data acquisition. The additional features 122 may be pre-stored in the memory 114. The pre-stored one or more additional features 122 of the temporal pattern of pulses may be used in addition to features defined by the RF definition signal 152 for the determining of the temporal pattern of pulses. The determined temporal pattern of pulses may be used for the determining of the control sequence 158.

Optionally, the memory 114 may, e.g., comprise a machine learning module 124 trained to output the control sequence 158 in response to receiving the RF definition signal 152 with an MRI sequence.

Fig. 7 illustrates an exemplary RF signal 150 comprising an exemplary MRI sequence 156 configured for acquiring MRI data. The MRI sequence 156 shows a repetitive temporal pattern of pulses 170, 172. In the example depicted, the MRI sequence 156 compromises two RF pulses 170, 172 each, i.e., an excitation pulse 170 and a 180° inversion pulse 172. In addition, an exemplary control sequence 158 mirroring the temporal pattern of pulses of the MRI sequence 156 is shown. According to the control sequence 158, a switch of a detuning assembly of an RF receiver antenna assembly is controlled to operate a receiver coil of the RF receiver antenna assembly in a detuned operational mode 182 during the transmission of the pulses 170, 172 of the MRI sequence 156 and in a tuned operational mode 180 during the rest of the time of the MRI sequence 156. For operating the switch, the RF receiver antenna assembly is equipped with a controlling unit configured for controlling the switch according to the control sequence 158.

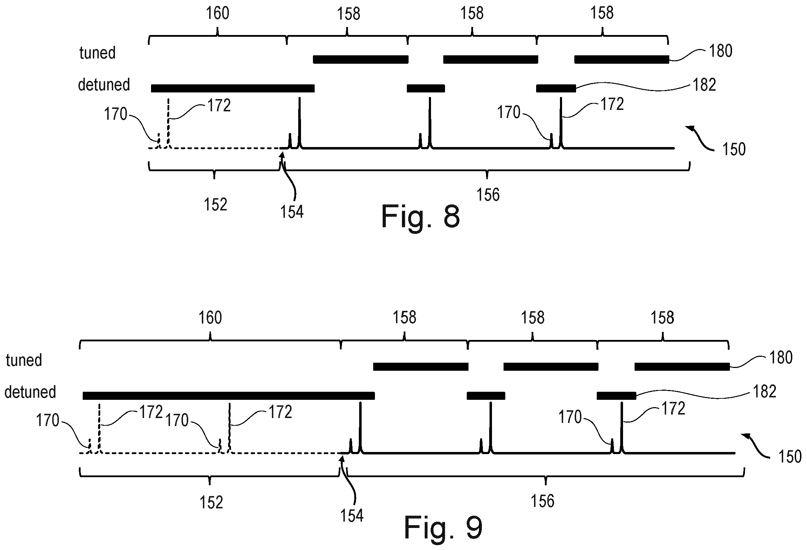

Fig. 8 illustrates an exemplary RF signal 150 comprising an RF definition signal 152 and an RF trigger signal 154. An RF receiver antenna assembly is equipped with a controlling unit. The controlling unit of the RF receiver antenna assembly may, e.g., comprise a digital receiver, which enables the controlling unit to detect and analyze a pulse sequence pattern, i.e., a temporal pattern of pulses 170, 172, comprised by the RF definition signal received via the receiver coil. The receiver coil may, e.g., be operated in a detune operational mode 182 as a default mode and the RF definition signal 152 may, e.g., be received via the receiver coil operated in the default mode.

The RF definition signal 152 may, e.g., be a first repetition of a pulse sequence of the RF signal 150 and transmitted at an off-resonance frequency, i.e., outside an MRI frequency bandwidth. The controlling unit may be configured to determine pulse sequences transmitted at an off-resonance frequency to be RF definition signal 152 and use the same to determine a control sequence 158 for controlling a switch of a detuning assembly. According to the control sequence 158, the switch is controlled to operate the receiver coil in the detuned operational mode 182 during a transmission of the pulses 170, 172 of the MRI sequence and in a tuned operational mode 180 during the rest of the MRI sequence, i.e., when no pulses 170, 172 are received.

In the example depicted, the pulse sequence compromises two RF pulses 170, 172, e.g., an excitation pulse 170 and a 180° inversion pulse 172. The following repetitions of pulses of the RF signal 150 are on target frequency, i.e., the MRI RF frequency within the MRI frequency bandwidth. This switch of the carrier frequency from an off-resonance frequency to the resonance frequency may be an RF trigger signal triggering the controlling unit to execute the control sequence 158 and automatically synchronize the execution of the control sequence 158 with the pulses 170, 172 transmitted on target frequency for an MRI data acquisition. The controlling unit may be configured to detect this switching of the carrier frequency, i.e., the RF trigger signal, and, in response to the detection of the RF trigger signal, automatically synchronize the execution of the control sequence 158 with the transmitted pulses 170, 172 of the MRI sequence 156.

For example, when triggered by vital signs, the transmission of MRI sequences 156 may pause. In this case, the receiver coil may just remain longer in the detuned operational mode 182 and wait for a pulse 170. For example, the next pulse 170 may be transmitted at another frequency, i.e., an off-resonance frequency, to indicate to notify the controlling unit of an upcoming MRI sequence, for which the control sequence is to be executed. This next pulse 170 may thus be used as an RF trigger signal triggering the controlling unit to switch the receiver coil again between the tuned operational mode 180 and the detuned operational mode 182 according to the control sequence 158. Whenever an MRI data acquisition is started or continued after a pause, i.e., re-started, an RF trigger signal may be received by the controlling unit via the receiver coil triggering the controlling unit to control the switch according to the control sequence 158. RF trigger signals for the start of an MRI data acquisition and a re-start of the MRI data acquisition may be identical or they may be different.

Fig. 9 illustrates a further exemplary RF signal 150 comprising an RF definition signal 152 and an RF trigger signal 154. The RF signal 150 depicted in Fig. 9 corresponds to the RF signal 150 depicted in Fig. 8. The difference is, that in case of the RF signal 150 of Fig. 9 the RF definition signal 152 comprises two pulse repetitions within the MRI sequence, i.e., the temporal pattern of the pulses 170, 172. When receiving the repeated pulses 170, 172 at the beginning of the second pulse sequence, the controlling unit can determine the end of the first and the beginning od the second pulse sequence of the RF definition signal 152. Thus, the controlling unit may reliably determine a temporal length of the pulse sequence and based thereon, e.g., a temporal length of the tuned operational mode 180 for the control sequence 158. The temporal length of the detuned operational mode 182 for the control sequence 158 may, e.g., be determined using the temporal length of the pulses 170, 172. The repetition of the pulses within the sequence may in general be used as a safety feature. The controlling unit may know, that the transmission of the actual MRI signal 156 starts after the two repetitions of the pulse sequence. The pulse sequence in the RF definition signal 152 may be repeated one or more times.

Like in Fig. 8, the switching of the carrier frequency may be used as the RF trigger signal 154 triggering the controlling unit to execute the control sequence 158. Alternatively or additionally, the RF definition signal 152 may at the same time be used as an RF trigger signal. For example, the controlling unit may be configured to execute the control sequence automatically at an end of the receiving of the RF definition signal 152. When the RF definition signal 152 transmits the pulse sequence twice, the controlling unit may use the first pulse sequence to determine the control sequence 158 and at the same time determine the temporal length of the first pulse sequence, which ends with the repetition of the pulses 170, 170, the end of the RF definition signal 152. The RF definition signal 152 ends after the repetition of the pulse sequence, i.e., its length is twice the determined temporal length of the first pulse sequence. Thus, the RF definition signal 152 may not only define a temporal pattern of pulses 170, 172, but also trigger the switching of the receiver coil controlled by a controlling unit.

For example, a temporal pattern of the pulses 170, 172 of the repeated MRI sequence may be determined and compared with a determined temporal pattern of pulses 170, 172 assigned to the determined control sequence 158. The switching of the RF receiver coil according to the control sequence 158 may be triggered by a determining of a matching of the temporal pattern of pulses 170, 172 of the repeated MRI sequence with the temporal pattern of pulses 170, 172 determined previously.

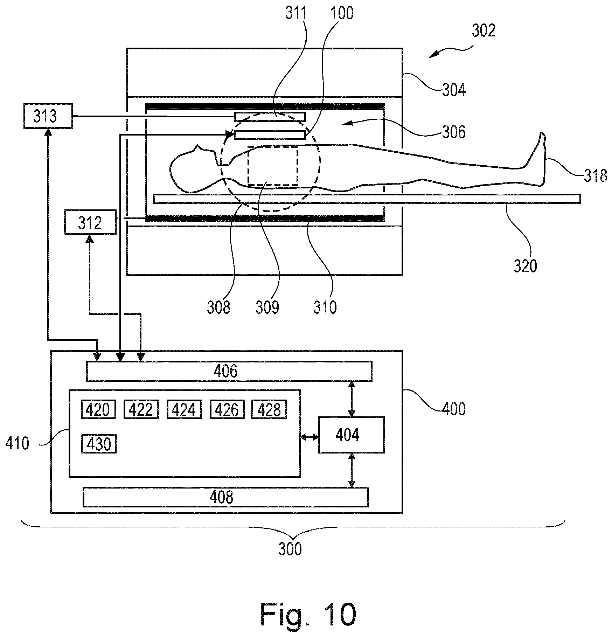

Fig. 10 illustrates an example of an MRI system 300 comprising an RF receiver antenna assembly 100. The MRI system 300 is controlled by a computer 400. The MRI system 300 comprises a magnet 304. The magnet 304 is a superconducting cylindrical type magnet with a bore 306 through it. The use of different types of magnets is also possible; for instance, it is also possible to use both a split cylindrical magnet and a so-called open magnet.

Within the bore 306 of the cylindrical magnet 304 there is a target zone 308, also referred to as imaging zone, where the magnetic field is strong and uniform enough to perform magnetic resonance imaging. A region of interest 309 is shown within the imaging zone 308. The magnetic resonance data that is acquired is typically acquired for the region of interest 309. A subject 318 is shown as being supported by a subject support 320 such that at least a portion of the subject 318 is within the imaging zone 308 and the region of interest 309.

Within the bore 306 of the magnet there is also a set of magnetic field gradient coils 310 which is used for acquisition of preliminary magnetic resonance data to spatially encode magnetic spins within the imaging zone 308 of the magnet 304. The magnetic field gradient coils 310 connected to a magnetic field gradient coil power supply 312. The magnetic field gradient coils 310 are intended to be representative. Typically, magnetic field gradient coils 310 contain three separate sets of coils for spatially encoding in three orthogonal spatial directions. The magnetic field gradient power supply 312 supplies current to the magnetic field gradient coils 310. The current supplied to the magnetic field gradient coils 310 is controlled as a function of time and may be ramped or pulsed.

Adjacent to the imaging zone 308 is an RF transmitter coil 311 for manipulating the orientations of magnetic spins within the imaging zone 308 and an RF receiver antenna assembly 100 comprising a receiver coil for receiving radio transmissions from the spins within the imaging zone 308. The RF receiver antenna assembly 100 may be an RF receiver antenna assembly according to any of the examples described herein. The RF transmitter coil 311 may also be referred to as a transmitter antenna. The RF transmitter coil 311 may contain multiple coil elements. The RF transmitter coil 311 is connected to an RF transmitter 313. It is understood that the RF transmitter coil 311 and the RF transmitter 313 are representative. The RF transmitter coil 311 may have multiple transmitter elements and the RF transmitter 313 may have multiple transmitter channels. It is further understood that the RF receiver antenna assembly 100 is representative. The RF receiver antenna assembly 100 may, e.g., comprise an RF receiver. The RF receiver antenna assembly 100 may, e.g., comprise multiple receiver coils.

The transmitter 313, the gradient controller 312, and the RF receiver antenna assembly 100 are shown as being connected to the hardware interface 406 of the computer 400. The computer 400 is intended to represent one or more computational or computing devices. The computer 400 is configured for acquiring medical imaging data as part of a control system of the MRI system 300. The computer 400 is shown as comprising a computation system 404. The computational system 404 is intended to represent one or more processors or processing cores or other computational systems that are located at one or more locations. The computational system 404 is shown as being connected to hardware interface 406, a user interface 408 and a memory 410. If other components are present, the hardware interface 406 may enable the computational system 404 to exchange commands and data with those other components.

The hardware interface 406 may for example enable the computational system 404 to control other components such as an MRI system 300. The computational system 404 is further shown as being connected to a user interface 408 which may for example enable an operator to control and operate the computer 400 and via the computer 400 the MRI system 300. The user interface 408 may, e.g., comprise an output and/or input device enabling a user to interact with the computer 400. The output device may, e.g., comprise a display device configured for displaying magnetic resonance images 426. The input device may, e.g., comprise a keyboard and/or a mouse enabling the user to insert control commands for controlling the computer 400 and via the computer 400 the MRI system 300. The computational system 404 is further shown as being connected to a memory 410. The memory 410 is intended to represent different types of memory which could be connected to the computational system 404 and may for example be a non-transitory storage medium.

The memory is shown as containing machine-executable instructions 420. The machine-executable instructions 420 enable the computational system 404 to perform tasks such as controlling other components to perform numerical tasks, as well as performing various data and image processing tasks. The machine-executable instructions 420 may, e.g., enable the computational system 404 to control the MRI system 300.

The memory 410 is further shown as containing pulse sequence commands 422. The pulse sequence commands 422 are commands or data which may be converted into such commands that are configured for controlling the MRI system 300 to acquire the MRI data 424 from the region of interest 309. The acquired MRI data 424 is used to reconstruct magnetic resonance images 426.

The memory 410 is further shown as containing definition signal commands 428. The signal commands 428 are commands or data which may be converted into such commands that are configured for controlling the MRI system 300 to send a wireless RF definition signal. The computer 400 may control the MRI system 300 using the definition signal commands 428 to send the RF definition signal as a wireless RF signal to the RF receiver antenna assembly 100 using, e.g., the RF transmitting coil 311. The RF definition signal may provide the RF receiver antenna assembly 100, i.e., a controlling unit of the RF receiver antenna assembly 100, with information enabling the controlling unit to determine a control sequence for controlling a switching of an RF receiver coil of the RF receiver antenna assembly 100 between a tuned operational mode and a detuned operational mode. For this purpose, a temporal pattern of pulses of an MRI sequence, e.g., defined by pulse sequence commands 422, may be determined using the RF definition signal.

Finally, the memory 410 is further shown as containing trigger signal command 430. The signal commands 430 are commands or data which may be converted into such commands that are configured for controlling the MRI system 300 to send a wireless RF trigger signal. The computer 400 may control the MRI system 300 using the trigger signal commands 430 to send the RF definition signal as a wireless RF signal to the RF receiver antenna assembly 100 using, e.g., the RF transmitting coil 311. The RF trigger signal may trigger the controlling unit of the RF receiver antenna assembly 100 to execute the control sequence determined using the RF definition signal.

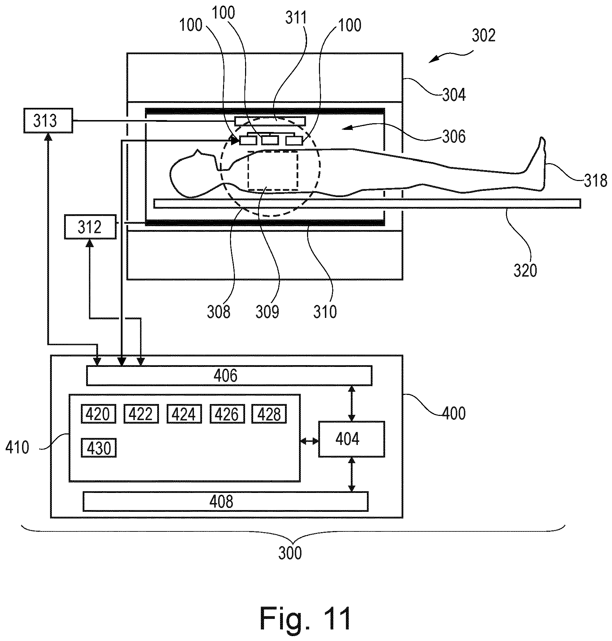

Fig. 11 illustrates another example of an MRI system 300. The MRI system 300 of Fig. 11 corresponds to the MRI system 300 of Fig. 10, wherein the MRI system 300 of Fig. 11 comprises a plurality of RF receiver antenna assemblies 100, each of which may comprise one or more receiver coils. The RF receiver antenna assemblies 100 may, e.g., be configured for a locally flexible placement. For example, the RF receiver antenna assemblies 100 may be placed near or directly on the subject 318. Like the multiple RF receiver antenna assemblies 100, the transmitter coil 311 may contain multiple coil elements and, e.g., be implemented in form of an array of coils.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

### REFERENCE SIGNS LIST

- 100: RF receiver antenna assembly
- 102: RF receiver coil
- 104: detuning assembly
- 105: switchable impedance
- 106: switch
- 108: controlling unit
- 110: receiver
- 112: computational component
- 114: memory
- 116: hardware interface
- 120: machine readable instructions
- 122: additional features
- 124: machine learning module
- 150: wireless RF signal
- 152: wireless RF definition signal
- 154: wireless RF trigger signal
- 156: MRI sequence
- 158: control sequence
- 160: default detuned operational mode
- 170: excitation pulse
- 172: inversion pulse
- 180: tuned operational mode
- 182: detuned operational mode
- 300: MRI system
- 302: coil
- 304: magnet
- 306: bore of magnet
- 308: imaging zone
- 309: region of interest
- 310: magnetic field gradient coils
- 311: radio-frequency transmitter coil
- 312: magnetic field gradient coil power supply
- 313: transmitter
- 318: subject
- 320: subject support
- 400: computer
- 404: computational system
- 406: hardware interface
- 408: user interface
- 410: memory
- 420: machine executable instructions
- 422: pulse sequence commands
- 424: magnetic resonance imaging data
- 426: magnetic resonance images
- 428: definition signal commands
- 430: trigger signal commands

## Claims

1. A radio frequency receiver antenna assembly (100) comprising a radio frequency receiver coil for magnetic resonance imaging (102), a detuning assembly (104) configured for operating the receiver coil (102) in a tuned operational mode (180) and a detuned operational mode (182), and a controlling unit (108), the detuning assembly (104) comprising a switch (106) configured for switching between the tuned operational mode (180) and the detuned operational mode (182), the controlling unit being configured for controlling the switch (106) in response to a wireless radio frequency trigger signal (154) being received via the receiver coil (102),
the radio frequency receiver antenna assembly (100) being configured for:
- receiving a wireless radio frequency definition signal (152) by the controlling unit (108) via the receiver coil (102) defining a magnetic resonance imaging sequence comprising one or more radio frequency pulses;
- in response to the receiving of the wireless radio frequency definition signal (152), determining a control sequence (158) for controlling the switch (106) by the controlling unit (108) using the received wireless radio frequency definition signal (152), the control sequence (158) controlling the switch (106) to operate the receiver coil (102) in the detuned operational mode (182) during a transmission of the pulses of the radio magnetic resonance imaging sequence and in the tuned operational mode (180) during the rest of the magnetic resonance imaging sequence;
- receiving the wireless radio frequency trigger signal (154) by the controlling unit (108) via the receiver coil (102);
- in response to the receiving of the wireless radio frequency trigger signal (154), switching the receiver coil (102) between the tuned operational mode (180) and the detuned operational mode (182) according to the control sequence (158) by the controlling unit (108) using the switch (106).

2. The radio frequency receiver antenna assembly (100) of claim 1, the determining of the control sequence (158) comprising determining a temporal pattern of pulses (170, 172) of the magnetic resonance imaging sequence using the wireless radio frequency definition signal (152), the determined temporal pattern of pulses (170, 172) being used for the determining of the control sequence (158).

3. The radio frequency receiver antenna assembly (100) of claim 2, the wireless radio frequency definition signal (152) comprising the magnetic resonance imaging sequence, the magnetic resonance imaging sequence being used for the determining of the temporal pattern of pulses (170, 172).

4. The radio frequency receiver antenna assembly (100) of claim 3, the wireless radio frequency definition signal (152) further comprising at least one repetition of the magnetic resonance imaging sequence.

5. The radio frequency receiver antenna assembly (100) of claim 2, the wireless radio frequency definition signal (152) comprising definitions of one or more features of the temporal pattern of pulses (170, 172) encoded in the wireless radio frequency definition signal (152), the controlling unit (108) being configured to decode the one or more features of the temporal pattern of pulses (170, 172) using the wireless radio frequency definition signal (152), the decoded one or more features of the temporal pattern of pulses (170, 172) being used for the determining of the temporal pattern of pulses (170, 172).

6. The radio frequency receiver antenna assembly (100) of claim 5, the controlling unit (108) being configured to decode the one or more features of the temporal pattern of pulses (170, 172) using one or more of the following: an amplitude modulation analysis, a frequency modulation analysis, a Manchester code analysis, a pulse-width modulation analysis.

7. The radio frequency receiver antenna assembly (100) of any of the previous claims 2 to 5, the controlling unit (108) comprising a memory (114), one or more additional features (122) of the temporal pattern of pulses (170, 172) being pre-stored in the memory (114), the pre-stored one or more additional features (122) of the temporal pattern of pulses (170, 172) being used for the determining of the temporal pattern of pulses (170, 172).

8. The radio frequency receiver antenna assembly (100) of any of the previous claims 2 to 5, the receiving of the wireless radio frequency trigger signal (154) comprises comparing a temporal pattern of pulses of a magnetic resonance imaging sequence comprised by the wireless radio frequency trigger signal (154) with the determined temporal pattern of pulses (170, 172), the switching of the receiver coil (102) according to the control sequence (158) being triggered by a determining of a matching of the temporal pattern of pulses (170, 172) of the wireless radio frequency trigger signal (154) with the determined temporal pattern of pulses (170, 172).

9. The radio frequency receiver antenna assembly (100) of any of the previous claims 2 to 6, the wireless radio frequency trigger signal (154) being the wireless radio frequency definition signal (152) defining the temporal pattern of pulses (170, 172) and triggering the switching of the receiver coil (102), the switching of the receiver coil (102) according to the control sequence (158) being triggered automatically at an end of the receiving of the wireless radio frequency definition signal (154).

10. The radio frequency receiver antenna assembly (100) of any of the previous claims 1 to 6, the wireless radio frequency trigger signal (154) being a pre-defined trigger signal (154), the controlling unit (108) being configured to start the switching of the receiver coil (102) according to the control sequence (158) at a pre-defined temporal duration after the receiving of the pre-defined trigger signal (154).

11. The radio frequency receiver antenna assembly (100) of any of the previous claims, the radio frequency receiver antenna assembly (100) being configured to operate the receiver coil (102) by default in the detuned operational mode (182).

12. A magnetic resonance imaging system (300) comprising the radio frequency receiver antenna assembly (100) of any of the previous claims.

13. A computer program comprising machine executable instructions (120) for execution by a computational component (112) of a controlling unit (108) of a radio frequency receiver antenna assembly (100), the radio frequency receiver antenna assembly (100) comprising a radio frequency receiver coil for magnetic resonance imaging (102), a detuning assembly (104) configured for operating the receiver coil (102) in a tuned operational mode (180) and a detuned operational mode (182), and the controlling unit (108), the detuning assembly (104) comprising a switch (106) configured for switching between the tuned operational mode (180) and the detuned operational mode (182), the controlling unit being configured for controlling the switch (106) in response to a wireless radio frequency trigger signal (154) being received via the receiver coil (102),
execution of the machine executable instructions (120) by the computational component (112) causing the computational component (112) to control the radio frequency receiver antenna assembly (100) to:
- receive a wireless radio frequency definition signal (152) by the controlling unit (108) via the receiver coil (102) defining a magnetic resonance imaging sequence comprising one or more radio frequency pulses;
- in response to the receiving of the wireless radio frequency definition signal (152), determine a control sequence (158) for controlling the switch (106) by the controlling unit (108) using the received wireless radio frequency definition signal (152), the control sequence (158) controlling the switch (106) to operate the receiver coil (102) in the detuned operational mode (182) during a transmission of the pulses of the magnetic resonance imaging sequence and in the tuned operational mode (180) during the rest of the magnetic resonance imaging sequence;
- receive the wireless radio frequency trigger signal (154) by the controlling unit (108) via the receiver coil (102);
- in response to the receiving of the wireless radio frequency trigger signal (154), switch (106) the receiver coil (102) between the tuned operational mode (180) and the detuned operational mode (182) according to the control sequence (158) by the controlling unit (108) using the switch (106).

14. A method for controlling a radio frequency receiver antenna assembly (100) comprising a radio frequency receiver coil for magnetic resonance imaging (102), a detuning assembly (104) configured for operating the receiver coil (102) in a tuned operational mode (180) and a detuned operational mode (182), and a controlling unit (108), the detuning assembly (104) comprising a switch (106) configured for switching between the tuned operational mode (180) and the detuned operational mode (182), the controlling unit being configured for controlling the switch (106) in response to a wireless radio frequency trigger signal (154) being received via the receiver coil (102),
the method comprising:
- receiving a wireless radio frequency definition signal (152) by the controlling unit (108) via the receiver coil (102) defining a magnetic resonance imaging sequence comprising one or more radio frequency pulses;
- in response to the receiving of the wireless radio frequency definition signal (152), determining a control sequence (158) for controlling the switch (106) by the controlling unit (108) using the received wireless radio frequency definition signal (152), the control sequence (158) controlling the switch (106) to operate the receiver coil (102) in the detuned operational mode (182) during a transmission of the pulses of the magnetic resonance imaging sequence and in the tuned operational mode (180) during the rest of the magnetic resonance imaging sequence;
- receiving the wireless radio frequency trigger signal (154) by the controlling unit (108) via the receiver coil (102);
- in response to the receiving of the wireless radio frequency trigger signal (154), switching the receiver coil (102) between the tuned operational mode (180) and the detuned operational mode (182) according to the control sequence (158) by the controlling unit (108) using the switch (106).
